# EUROPÄISCHE PATENTSCHRIFT

(11) **EP 2 313 913 B1**
(45) Veröffentlichungstag und Bekanntmachung des Hinweises auf die Patenterteilung: **09.01.2013**
(21) Anmeldenummer: 09777811.2
(22) Anmeldetag: 11.08.2009
(51) Int. Cl.: H01L 21/311, H01L 21/3213, H01L 21/3065

(54) **VERFAHREN ZUM ELEKTRONENSTRAHLINDUZIERTEN ÄTZEN VON MIT GALLIUM IMPLANTIERTEN SCHICHTEN**
METHOD FOR ELECTRON BEAM INDUCED ETCHING OF LAYERS IMPLANTED WITH GALLIUM
PROCÉDÉ DE GRAVURE, INDUITE PAR UN FAISCEAU D'ÉLECTRONS, DE COUCHES IMPLANTEES PAR DU GALLIUM

(30) Priorität: 14.08.2008 DE 102008037951
(43) Veröffentlichungstag der Anmeldung: 27.04.2011
(73) Patentinhaber: Carl Zeiss SMS GmbH, 07745 Jena (DE)
(72) Erfinder: AUTH, Nicole, 65462 Gustavsburg (DE); SPIES, Petra, 55130 Mainz (DE); BECKER, Rainer, 64319 Pfungstadt (DE); HOFMANN, Thorsten, 63110 Rodgau (DE); EDINGER, Klaus, 64646 Heppenheim (DE)
(74) Vertreter: Wegner, Hans
(86) Internationale Anmeldenummer: PCT/EP2009/005823
(87) Internationale Veröffentlichungsnummer: WO 2010/017963

(56) Entgegenhaltungen:
- US-A- 4 226 666
- US-A- 5 683 547
- US-A1- 2003 224 601
- WATANABE H ET AL: "LOW-DAMAGE ELECTRON-BEAM-ASSISTED DRY ETCHING OF GAAS AND AIGAAS USING ELECTRON CYCLOTRON RESONANCE PLASMA ELECTRON SOURCE" JOURNAL OF VACUUM SCIENCE & TECHNOLOGY B: MICROELECTRONICSPROCESSING AND PHENOMENA, AMERICAN VACUUM SOCIETY, NEW YORK, NY, US, Bd. 11, Nr. 6, 1. November 1993 (1993-11-01), Seiten 2288-2293, XP007910352 ISSN: 0734-211X
- RANDOLPH S J ET AL: "Focused, nanoscale electron-beam-induced deposition and etching" CRITICAL REVIEWS IN SOLID STATE AND MATERIALS SCIENCES, CRC PRESS, BOCA RATON, FL, US, Bd. 31, Nr. 3, 1. September 2006 (2006-09-01), Seiten 55-89, XP009098857 ISSN: 1040-8436
- YOSHIDA ET AL: "The effect of EB irradiation with and without hot-jet Cl2 on an ultra-thin GaN layer for selective etching" APPLIED SURFACE SCIENCE, ELSEVIER, AMSTERDAM, NL, Bd. 100-101, 2. Juli 1996 (1996-07-02), Seiten 184-188, XP005296519 ISSN: 0169-4332

## Beschreibung

### 1. Technisches Gebiet

Die vorliegende Erfindung betrifft ein Verfahren zum elektronenstrahlinduzierten Ätzen von Schichten mit implantiertem Gallium.

### 2. Stand der Technik

Ätzprozesse spielen in der Industrie, insbesondere in der Halbleitertechnologie eine wichtige Rolle. Mit ihrer Hilfe werden feine Strukturen bis in den Nanometerbereich präpariert. Ätzprozesse haben ferner eine wichtige Funktion bei der Reparatur von Photolithographiemasken.

Für die Herstellung von feinen Strukturen mittels Ätzprozessen, wie sie in der Halbleitertechnologie verwendet werden, ist aus dem Stand der Technik das Ätzen unter Einwirkung eines fokussierten Ionenstrahls unter dem Akronym FIB (focused ion beam) bekannt. Die FIB Technologie ist beispielsweise in der US 4 639 301 offenbart. Der besondere Vorteil der FIB Technologie liegt darin, dass sich bei großer Ätzrate glatte und steile Seitenwände, d.h. Strukturen mit großem Aspektverhältnis, herstellen lassen. Das Aspektverhältnis bezeichnet das Verhältnis aus der Tiefe bzw. Höhe einer Struktur zu ihrer kleinsten lateralen Ausdehnung.

Bei der FIB Technologie besteht der Ionenstrahl in der Regel aus Gallium (Ga)-Ionen. Bei der Reparatur von Photolithographiemasken führt die Implantation von Gallium in das Quartzsubtrat zu einer Verschlechterung des Transmissionsverhaltens gegenüber der zur Belichtung verwendeten Ultraviolett (UV)-Strahlung. In der US 2004/0226814 A1 wird ein Verfahren offenbart, mit dessen Hilfe das Transmissionsverhalten eines durch Beschuss mit Ga-Ionen gegenüber UV-Strahlung eingetrübten Quarzsubstrats wieder weitgehend hergestellt werden kann, ohne dass sich die Dicke der Substratschicht signifikant ändert. Dazu werden die Bereiche des Quarzsubstrats, in denen Ga-Ionen implantiert sind, mit Hilfe eines Elektronenstrahls und des Ätzgasgases Xenondifluorid (XeF₂) gereinigt. Eine essentielle Bedingung ist dabei, dass das Substrat durch die kombinierte Einwirkung des Elektronenstrahls und von XeF₂ nicht geätzt wird. Ein Abtrag des Substratmaterials würde seine Dicke lokal ändern und bei der Belichtung mit UV Strahlung würden dadurch Phasenfehler entstehen, die zu Abbildungsfehlern der Photolithographiemaske führen. Damit würde letztlich der Mangel unzureichender Transmission durch den Mangel unzureichender Abbildungsqualität in der Photolithographiemaske ersetzt.

Die Implantation von Gallium in eine Schicht unterhalb der zu bearbeitenden Schicht ist ein generelles Problem der FIB Technologie und tritt neben dem oben beschriebenen Maskenreparaturprozess auch beim sogenannten Circuit Editing auf, d.h. beim gezielten Verändern von mikroskopischen Strukturen in der Halbleitertechnologie, indem beispielsweise Leiterbahnen des Bauteils nachträglich punktgenau durchtrennt oder miteinander verbunden werden.

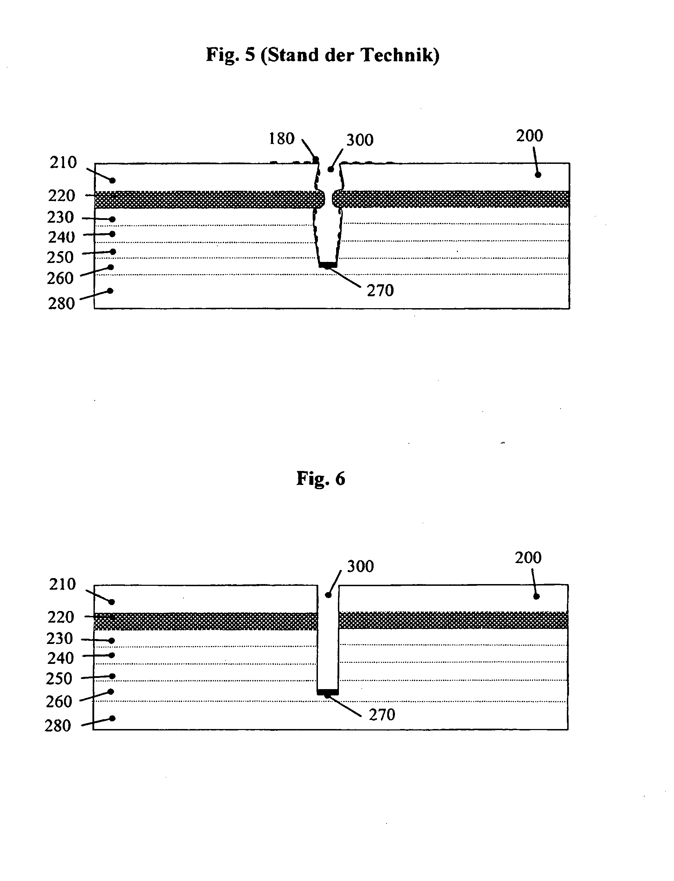

Die Implantation von Gallium in eine Halbleiterschicht, wie sie beispielsweise durch den Beschuss von Gallium bei der FIB Technologie erfolgt, erschwert die weitere Prozessierung dieser Schicht ganz erheblich. Insbesondere das Ätzen dieser Schicht erweist sich als außerordentlich schwierig. Beim Abtragen größerer Volumina, in die Gallium implantiert wurde, verbleiben in der Regel inerte Residua, die für die weitere Prozessierung ein Problem darstellen. Als Folge des schwierigen Abtragens einer mit Gallium verunreinigten Schicht ergibt das Ätzen von tiefen Kontaktlöchern in ein Mehrschichtsystem, das eine mit Gallium verunreinigte Schicht umfasst, im Bereich dieser Schicht eine Engstelle (vgl. Fig. 5). Zudem erschwert die Anlagerung von Galliumresten an den in einem Mehrschichtsystem vorhandenen weiteren Schichten signifikant deren weitere Prozessierung. Ein weiterer gravierender Nachteil der FIB Technologie besteht darin, dass ein Großteil des gesputterten Materials sich an anderen Stellen der Probe oder in der Vakuumkammer wieder ablagert.

Der wissenschaftliche Artikel "Low-damage electron-beam-assisted dry etching of GaAs and AlGaAs using electron cyclotron resonance plasmas electron source" von H. Watanabe und S. Matsui, J. Vac. Sci. Technol. B 11(6) Nov/Dec 1993, Seiten 2288-2293, XPO07910352 ISSN: 0734-211X beschreibt das Verwenden eines Elektronenstrahls zum Induzieren einer Oberflächenreaktion.

Das US Patent mit der Nr. 5 683 547 offenbart ein Bearbeitungsverfahren und eine Vorrichtung, die einen fokussierten Energiestrahl, wie etwa einem Ionenstrahl oder einem Elektronenstrahl, verwenden, um eine Probe durch Bestrahlen in einer ätzenden Gasatmosphäre zu bearbeiten. Als Ätzgas wird ein Mischgas verschiedener herkömmlicher Zusammensetzung eingesetzt und das Gas wird gleichmäßig an die zu ätzende Fläche geliefert und zumindest einer der Bestandteile eines solchen Mischgases ist ein spontan reaktionsfreudiges Gas, das eingesetzt wird, um die Probe spontan und isotrop zu ätzen.

Der vorliegenden Erfindung liegt daher das Problem zu Grunde, ein Verfahren zum im Wesentlichen rückstandsfreien Ätzen einer mit Gallium verunreinigten Schicht anzugeben und auf diese Weise die oben genannten Nachteile zumindest zum Teil zu vermeiden.

### 3. Zusammenfassung der Erfindung

Gemäß der vorliegenden Erfindung wird dieses Problem durch ein Verfahren nach Anspruch 1 gelöst. In einer Ausführungsform umfasst das Verfahren zum elektronenstrahlinduzierten Ätzen einer mit Gallium verunreinigten Schicht das Bereitstellen zumindest einer ersten halogenhaltigen Verbindung als ein Ätzgas an einer Stelle, an der ein Elektronenstrahl auf die Schicht trifft, und das Bereitstellen zumindest einer zweiten halogenhaltigen Verbindung als ein Präkursorgas an dieser Stelle.

Die Anmelderin hat überraschend herausgefunden, dass sich eine mit Gallium verunreinigte Schicht beim elektronenstrahlinduzierten Ätzen unter Verwendung eines geeigneten Präkursorgases entfernen lässt. Durch die Zugabe des Präkursorgases lassen sich beim Abtragen größerer mit Gallium verunreinigter Volumina die aus dem Stand der Technik bekannten inerten Residua weitgehend vermeiden. Beim Ätzen eines Mehrschichtsystems mit zumindest einer mit Gallium verunreinigter Schicht beseitigt oder reduziert die Zugabe eines geeigneten Präkursorgases zumindest die Anlagerung von Galliumresten an andere Schichten. Das erfindungsgemäße Verfahren gestattet somit ein im Wesentlichen rückstandsfreies Ätzen von mit Gallium verunreinigten Schichten. Zudem kann die Zufuhr des Präkursorgases beim Ätzen von mit Gallium verunreinigten Schichten die Selektivität des Ätzprozesses gegenüber Schichten ohne implantiertes Gallium verringern. Damit kann das Entstehen von Engstellen beim Ätzen von Kontaktlöchern verhindert werden.

In einer bevorzugten Ausführungsform des erfindungsgemäßen Verfahrens wird als erste halogenhaltige Verbindung Xenondifluorid (XeF₂) verwendet. Es ist jedoch denkbar auch andere halogenhaltige Verbindungen, beispielsweise ein Halogen (Brom (Br₂) und/oder Jod (I₂)), oder andere Verbindungen als Ätzgase einzusetzen, wie etwa Schwefelhexafluorid (SF₆) oder Sauerstoff (O₂).

Vorzugsweise wird Chlor (Cl₂) als zweite halogenhaltige Verbindung eingesetzt. Das erfindungsgemäße Verfahren ist jedoch nicht auf die Verwendung von Cl₂ als Präkursorgas beschränkt. Es ist denkbar, andere Präkursorgase einzusetzen, wie etwa ein anderes Halogen, halogenhaltige Verbindungen oder oxidierende Verbindungen.

In einer bevorzugten Ausführungsform des erfindungsgemäßen Verfahrens werden gute Ätzergebnisse bei kontinuierlicher Bereitstellung der zweiten halogenhaltigen Verbindung während des Ätzens erzielt. In einer besonders bevorzugten Ausführungsform des erfindungsgemäßen Verfahrens ergeben sich sehr gute Ätzresultate bei einem Gasmengenstrom der zweiten halogenhaltigen Verbindung von 0,1 sccm (Standardkubikzentimeter pro Minute).

Vorzugsweise wird die erste halogenhaltige Verbindung während des Ätzens variierend bereitgestellt. In einer Ausführungsform wird die erste halogenhaltige Verbindung mit einem Duty Cycle von 1:5 gechoppt mit einem Takt von 30 s (Sekunden) bereitgestellt.

In einer Ausführungsform des erfindungsgemäßen Verfahrens ist beim Ätzen eines Kontaktlochs durch ein Mehrschichtsystem, das zumindest eine mit Gallium verunreinigte Schicht umfasst, der Gasmengenstrom der zweiten halogenhaltigen Verbindung beim Ätzen der zumindest einen mit Gallium verunreinigten Schicht größer als beim Ätzen von nicht mit Gallium vereinigten Schichten.

In einer weiteren bevorzugten Ausführungsform des erfindungsgemäßen Verfahrens verringern eine Kühlfalle und/oder eine Ultraviolett-Lampe den Wasserdampfpartialdruck in einer Vakuumkammer.

Bevorzugt wird der Elektronenstrahl des Elektronenstrahlgeräts zusätzlich oder alternativ zum Untersuchen der zu ätzenden und/oder der geätzten Oberfläche der Schicht eingesetzt. Neben oder parallel zu der Elektronenstrahlmikroskopie können auch andere Verfahren eingesetzt werden, wie beispielsweise Auger-Elektronenspektroskopie (AES), Photoelektronenspektroskopie (XPS), Rastertunnelmikroskopie und/oder Rasterkraftmikroskopie. Ferner ist eine Kombination dieser Techniken möglich.

Gemäß einem weiteren Aspekt der vorliegenden Erfindung weist eine Vorrichtung zum elektronenstrahlinduzierten Ätzen einer Schicht mit implantiertem Gallium einen Einlass für zumindest eine erste halogenhaltige Verbindung auf. Der Einlass befindet sich an einer Stelle, an der ein Elektronenstrahl auf die Schicht trifft. Ferner weist die Vorrichtung einen Einlass für zumindest eine zweite halogenhaltige Verbindung als ein Präkursorgas an dieser Stelle auf.

Weitere Ausführungsformen des erfindungsgemäßen Verfahrens sind in weiteren abhängigen Patentansprüchen definiert.

### 4. Beschreibung der Zeichnungen

In der folgenden detaillierten Beschreibung werden derzeit bevorzugte Ausführungsbeispiele der Erfindung unter Bezugnahme auf die Zeichnungen beschrieben, wobei
- Fig. 1: eine schematische Darstellung einer beispielhaften Vorrichtung zur Durchführung des Verfahrens zeigt, wobei eine in einer Vakuumkammer befindliche Probe mit zumindest einer mit Gallium verunreinigten Schicht durch die kombinierte Einwirkung eines Ätzgases, eines Präkursorgases und eines fokussierten Elektronenstrahls geätzt werden kann;
- Fig. 2: einen schematischen vergrößerten Schnitt durch ein Mehrschichtsystem mit einer großvolumigen mit Gallium verunreinigten Schicht zeigt, das mit einem Verfahren nach dem Stand der Technik geätzt wird;
- Fig. 3: einen schematischen vergrößerten Schnitt durch ein Mehrschichtsystem mit einer großvolumigen mit Gallium verunreinigten Schicht zeigt, das mit einer Ausführungsform des erfindungsgemäßen Verfahrens geätzt wird;
- Fig. 4: eine schematische vergrößerte Darstellung eines durch mehrere Schichten eines Mehrschichtsystems geätzten Vias zeigt, das eine mit Gallium verunreinigte Schicht aufweist;
- Fig. 5: einen schematischen Schnitt durch das Via der Fig. 4 zeigt, wenn für die Ätzung ein Verfahren des Standes der Technik verwendet worden ist; und
- Fig. 6: einen schematischen Schnitt durch das Via der Fig. 4 zeigt, wenn die Ätzung mit einem erfindungsgemäßen Verfahren durchgeführt worden ist.

### 5. Detaillierte Beschreibung bevorzugter Ausführungsbeispiele

Im Folgenden werden bevorzugte Ausführungsformen des erfindungsgemäßen Verfahrens und der erfindungsgemäßen Vorrichtung genauer erläutert.

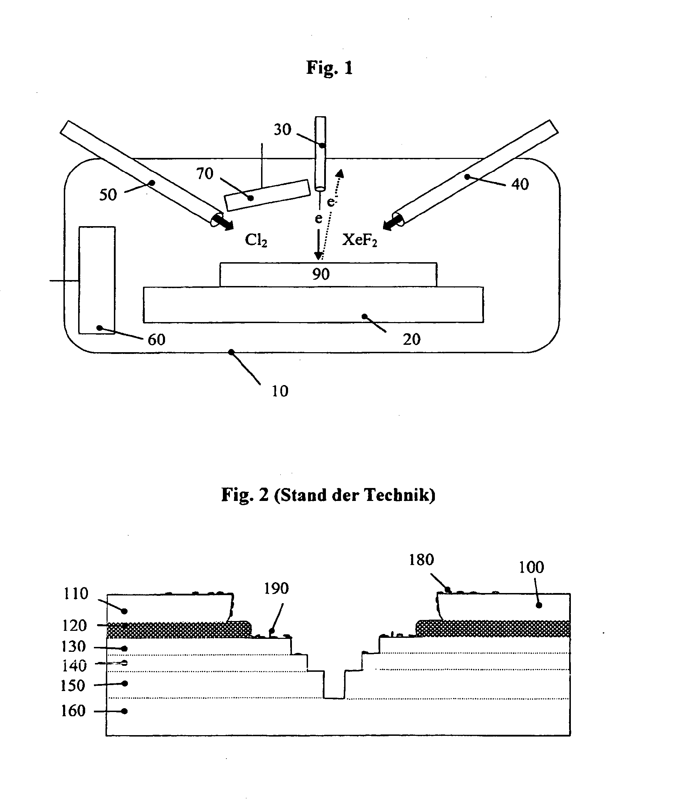

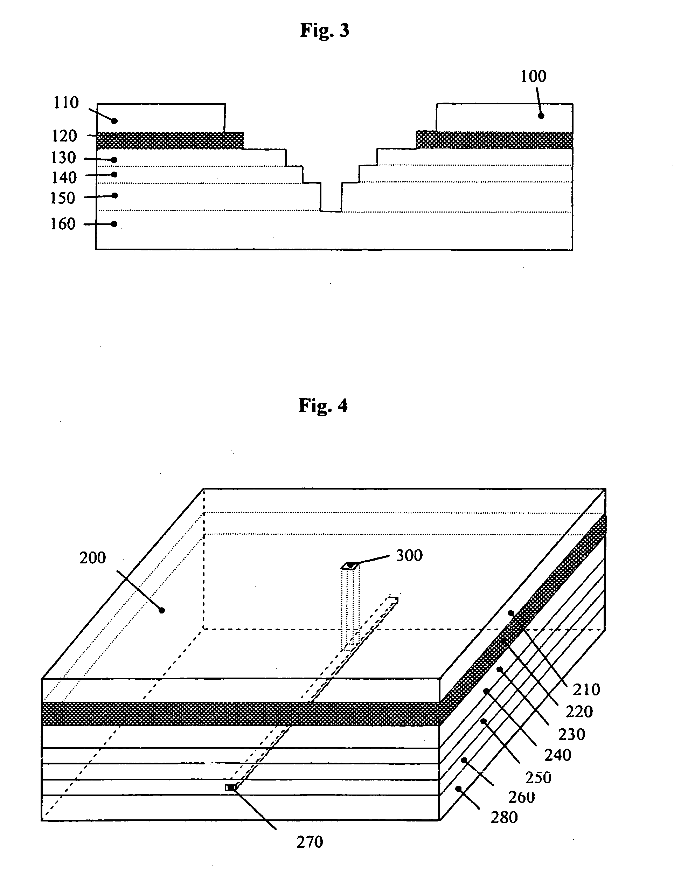

Wie in Fig. 1 schematisch dargestellt, wird in einer Vakuumkammer 10, eine zu ätzende Probe 90, die in den Figuren 2 und 3 ein Mehrschichtsystem 100 und in den Figuren 4 - 6 ein Mehrschichtsystem 200 umfasst, auf einem Probenhalter 20 angeordnet. Der Elektronenstrahl zur Durchführung des erfindungsgemäßen Verfahrens stammt aus einem Elektronenstrahlgerät 30, das beispielsweise ein gegebenenfalls modifiziertes Rasterelektronenmikroskop ist.

In dem in Fig. 1 schematisch dargestellten bevorzugten Ausführungsbeispiel der vorliegenden Erfindung wird als Ätzgas die halogenhaltige Verbindung XeF₂ über den Einlass 40 in die Vakuumkammer 10 gelassen. Neben XeF₂ kommen auch andere Halogene, beispielsweise Cl₂, Br₂ und/oder I₂ sowie andere halogenhaltige Verbindungen in Betracht, wie z.B. SF₆. Neben halogenhaltigen Verbindungen sind auch Wasser (H₂O), Stickstoffmonoxyd (NO), Stickstoffdioxyd (NO₂), Ammoniak (NH₃) und andere reaktive Substanzen denkbar. Das erfindungsgemäße Verfahren lässt ferner den gleichzeitigen Einsatz von mehr als einem Ätzgas zu. Deren Mischungsverhältnis kann sich zudem während des Ätzprozesses ändern.

Das Präkursorgas Cl₂ wird in der in Fig. i präsentierten Ausführungsform über den Einlass 50 in die Vakuumkammer 10 eingeleitet. Es ist vorstellbar neben Cl₂ auch andere Halogene, wie etwa Br₂ und/oder I₂ und/oder andere halogenhaltige Verbindungen, beispielsweise SF₆ als Präkursorgase einzusetzen. Neben halogenhaltigen Verbindungen sind auch Wasser (H₂O), Stickstoffmonoxyd (NO), Stickstoffdioxyd (NO₂) Ammoniak (NH₃) und andere reaktive Substanzen denkbar. Als Präkursorgase können ferner zwei oder mehrere Gase bzw. Materialien zum Einsatz kommen und deren Mischungsverhältnis kann sich im Laufe des Ätzprozesses ändern.

Sowohl XeF₂ als auch Cl₂ werden über geeignete Dosierventile (in Fig. 1 nicht dargestellt) durch die entsprechenden Einlässe 40, 50 auf das zu ätzende Mehrschichtsystem 100, 200 aufgebracht. Dabei ist es möglich, die beiden Gase XeF₂ und Cl₂ über getrennte Dosierventile aber einen gemeinsamen Einlass zuzuführen (in Fig. 1 nicht dargestellt). Alternativ zu einem auf die zu ätzende Schicht gerichteten Gaseineinlass, können die erste und/oder die zweite halogenhaltige Verbindung auch ungerichtet in die Vakuumkammer 10 eingelassen werden.

Die Dosierungen von XeF₂ und Cl₂ können zeitlich konstant sein. Es ist ferner möglich, die Dosierungen der beiden Gase und/oder eines der beiden Gase während des Ätzprozesses zeitlich zu ändern ("chopping"). Bei dem Ätzen einer mit Gallium verunreinigten Halbleiterschicht werden gute Ergebnisse erzielt, wenn das Präkursorgas kontinuierlich mit einem Gasmengenstrom von 0,1 sccm bereitgestellt wird. Gleichzeitig wird das Ätzgas XeF₂ vorzugsweise bei einer Temperatur von 273 K zeitlich variierend bereitgestellt. Dabei beträgt der Duty Cycle 1:5 bei einer Taktdauer von 30 s. Dies bedeutet, es wird über den Einlass 40 für 5 s XeF₂ in die Vakuumkammer 10 geleitet und für die nächsten 25 s wird mit Hilfe eines Ventils in dem Einlass 40 (in Fig. 1 nicht gezeigt) die Zufuhr des Ätzgases unterbrochen Das erfindungsgemäße Verfahren kann beispielsweise bei einem Gasmengenstrom von etwa 0,5 sccm (Standardkubikzentimeter pro Minute) ausgeführt werden.

Das elektronenstrahlinduzierte Ätzen unter Verwendung des Präkursorgases Chlor bringt einige apparative Herausforderungen mit sich. In einer unbehandelten Vakuumkammer 10 eines Elektronenstrahlgeräts 30 setzt die Reaktivität von Chlor soviel Restgas, beispielsweise Kohlenwasserstoffe in der Vakuumkammer 10 frei, dass die Deposition des freigesetzten Restgases auf der zu ätzenden Probe 90 das Ätzen erschwert. Ein weiterer wahrscheinlicher Reaktionspfad in der Vakuumkammer 10 bei der Zufuhr von Chlor, der zusätzlich geeignete Moleküle für die Deposition auf der zu ätzenden Schicht erzeugt, ist die spontane Reaktion des Chlors mit den in der Vakuumkammer 10 als Restgas vorhandenen Wassermolekülen zu Chlorwasserstoff (HCl). Bei HCl handelt es sich um eine polare Verbindung, die wesentlich besser auf der zu ätzenden Probe 90 haftet als die weniger polaren Wassermoleküle. Wasserdampf desorbierende Maßnahmen in der Vakuumkammer 10 sind daher hilfreich.

Um den im vorhergehenden Abschnitt beschriebenen Kontaminationsproblemen beim Einleiten von Chlor durch den Einlass 50 in die Vakuumkammer 10 vorzubeugen können verschiedene Maßnahmen ergriffen werden. Als nicht abschließende Beispiele seien an dieser Stelle genannt das Ausheizen der Vakuumkammer 10, deren Reinigung mit Hilfe eines Plasmas, die Verwendung einer Kryopumpe oder einer Kühlfalle 60 zur Erhöhung der Pumpleistung für Wasser sowie die Unterstützung der Desorption von Wasser von den Oberflächen der Vakuumkammer 10 und der Probe 90 durch Bestrahlung mit ultravioletten Licht.

Die Parameter des Elektronenstrahls können in Abhängigkeit von der Materialzusammensetzung der mit Gallium verunreinigten Schicht angepasst werden. In einem beispielhaften Parametersatz wird ein Elektronenstrahl mit einer Elektronenergie von 1 keV, einer Stromstärke von 50 pA einer Dwell time von 50 ns und einer Refresh time von 2 ms verwendet.

Zur Initialisierung der Ätzreaktion wird vorzugsweise ausschließlich ein fokussierter Elektronenstrahl verwendet. Allerdings könnten zusätzlich oder alternativ auch andere energieübertragende Mechanismen zum Einsatz kommen (z.B. ein fokussierter Laserstrahl und/oder ein unfokussierter Ionenstrahl).

Beim Ätzen von mit Gallium verunreinigter Schichten treten - wie bereits erwähnt - zwei verschiedene Probleme auf. So entstehen beim elektronenstrahlinduzierten Ätzen nach einem Verfahren aus dem Stand der Technik beim Abtragen großer Volumina Bereiche, die sich dem Abtragen durch den Ätzprozess hartnäckig widersetzen, sogenannte inerte Residua. Die Fig. 2 zeigt ein Mehrschichtsystem 100 dessen zweitoberste Schicht 120 mit Gallium verunreinigt ist. Die mit Gallium verunreinigte Schicht ist in eine Halbleiterschicht 120. Es ist jedoch auch möglich, dass Gallium durch Beschuss in eine zu ätzende Isolatorschicht eingebracht wird. Die anderen Schichten 110, 130, 140, 150 und 160 sind in dem Beispiel der Fig. 2 im Wesentlichen nicht mit Gallium verunreinigte Halbleiterschichten unterschiedlicher Zusammensetzung und/oder Dotierung. Die Fläche des abzutragenden Materials wird in dem Beispiel der Fig. 2 von Schicht zu Schicht stufenförmig kleiner. Durch den Ätzprozess soll ein Zugang zu der untersten Schicht 160 geschaffen werden. Aufgrund der unterschiedlichen Ätzraten der mit Gallium verunreinigten 120, der darüber liegenden Schicht 110 und der darunter liegenden Schicht 130, die im Wesentlichen kein implantiertes Gallium aufweisen, erfolgt ein Unterätzen der Schicht 110. Der Ausdruck im Wesentlichen bedeutet hier, wie auch an den anderen Stellen dieser Beschreibung eine Konzentration unterhalb der Nachweisgrenze bzw. eine Konzentration im Rahmen der Messgenauigkeit.

Bei einem elektronstrahlinduzierten Ätzprozess nach dem Stand der Technik verbleiben beim Ätzen der mit Gallium verunreinigten Schicht 120 nicht durch den Ätzprozess entfernbare inerta Residua 190. Beim Abtragen der mit Gallium verunreinigten Schicht 120 lagert sich zudem das aus der Schicht 120 entfernte Gallium als Galliumreste 180 an der zuerst geätzten obersten Schicht 110 an.

Die Fig. 3 zeigt das in Fig. 2 diskutierte Mehrschichtsystem 100 nach der Anwendung des erfindungsgemäßen Ätzverfahrens. Durch die Zuleitung des Präkursorgases wird die Selektivität der Ga-implantierten Schicht 120 gegenüber den anderen nicht mit Gallium verunreinigten Schichten 110, 130, 140, 150 und 160 deutlich reduziert. Damit wird ein Unterätzen der ersten Schicht 110 weitgehend vermieden. Die Verwendung des Präkursorgases Chlor ermöglicht einen im Wesentlichen rückstandsfreien Abtrag der mit Gallium verunreinigten Schicht 120. Inerte Residua 190 verbleiben im Wesentlichen nicht auf der Schicht 120. Galliumreste 180 lagern sich nicht oder in stark verringertem Umfang an der Schicht 110 an.

In der Fig. 4 ist schematisch dargestellt, wie in dem Mehrschichtsystem 200 durch mehrere Schichten 210 bis 260 ein Via 300 auf eine metallisch leitende Verbindung 270 freigeätzt wird. Wie in den Figuren 2 und 3 ist wiederum die zweitoberste Halbleiterschicht 220 mit Gallium verunreinigt. Die anderen Schichten 210, 220, 230, 240, 250, 260, 270 und 280 sind im Wesentlichen frei von Gallium-Verunreinigungen. Die oberste Schicht 210 des Mehrschichtsystems 200 ist eine Isolatorschicht. Die Schichten 230, 240, 250 und 280 sind Halbleiterschichten, Isolatoren und/oder Metalle unterschiedlicher Materialzusammensetzung und/oder Dotierung. Die metallisch leitende Verbindung 270 ist in die Isolatorschicht 260 eingebettet. Anders als in Fig. 4 dargestellt, kann Gallium bei Anwendung der FIB Technologie auch durch Ionenbeschuss in eine Isolatorschicht implantiert werden. Die darüberliegende und/oder die darunterliegende Schicht können Isolator- Metall- und/oder Halbleiterschichten sein. Mit einem erfindungsgemäßen Verfahren können diese Mehrschichtsysteme ebenfalls erfolgreich geätzt werden.

Die Fig. 5 zeigt einen Schnitt durch das Via 300 des Mehrschichtsystems 200 der Fig. 4 bei dem der Abtrag mit einem elektronenstrahlinduzierten Ätzverfahren nach dem Stand der Technik erfolgt ist. Aufgrund der unterschiedlichen Ätzraten der Schicht 220 einerseits und der Isolatorschicht 210 und der Halbleiterschicht 230 andererseits treten in diesen benachbarten Schichten 210 und 230 Unterätzungen auf. In der Schicht 220 führt die geringe Ätzrate zu der Ausbildung einer Engstelle. Das aus der Schicht 220 abgetragene Gallium lagert sich als Galliumreste 180 an den anderen Schichten 210, 230, 240, 250, 260 und 270 des Mehrschichtsystems 200 an.

Die Fig. 6 präsentiert ebenfalls einen Schnitt durch das Zugangsloch 300 des Mehrschichtsystems 200 der Fig. 4, wobei die Ätzung nunmehr mit einem erfindungsgemäßen Verfahren durchgeführt worden ist. Wie bereits bei der Diskussion der Fig. 4 erläutert, verringert die Einleitung von Chlor in die Vakuumkammer 10 über den Einlass 50 die Selektivität der Ätzrate zwischen den Schichten 210 und 230 auf der einen Seite und der Schicht 220 auf der anderen Seite. Somit kann einer Unterätzung der Schichten 210 und 230 wirksam begegnet werden und kann zudem das Ausbilden einer Engstelle im Bereich der Schicht 220 vermieden bzw. deutlich verringert werden. Als Folge des im Wesentlichen rückstandsfreien Ätzens des erfindungsgemäßen Verfahrens kann ferner die Anlagerung von Galliumresten 180 an den anderen Schichten 210, 230, 240, 250, 260 und 270 des Mehrschichtsystems 200 im Wesentlichen verhindert werden.

## Patentansprüche

1. Verfahren zum elektronenstrahlinduzierten Ätzen einer Schicht (120, 220) mit implantiertem Gallium, das Verfahren die folgenden Schritte aufweisend:
a. Bereitstellen zumindest einer ersten halogenhaltigen Verbindung als ein Ätzgas an einer Stelle, an der ein Elektronenstrahl auf die Schicht (120, 220) trifft; und
b. Bereitstellen zumindest einer zweiten halogenhaltigen Verbindung als ein Präkursorgas zum Entfernen des Galliums an dieser Stelle.

2. Verfahren nach Anspruch 1, wobei die zumindest eine erste halogenhaltige Verbindung Xenondifluorid umfasst.

3. Verfahren nach einem der Ansprüche 1 oder 2, wobei die zumindest eine zweite halogenhaltige Verbindung Chlor umfasst.

4. Verfahren nach einem der vorhergehenden Ansprüche, wobei das Bereitstellen der zweiten halogenhaltigen Verbindung während des Ätzens kontinuierlich erfolgt.

5. Verfahren nach Anspruch 4, wobei die zweite halogenhaltige Verbindung mit einem Gasmengenstrom von 0,1 Standardkubikzentimeter pro Minute bereitgestellt wird.

6. Verfahren nach einem der vorhergehenden Ansprüche, wobei das Bereitstellen der ersten halogenhaltigen Verbindung während des Ätzens variierend erfolgt.

7. Verfahren nach Anspruch 6, wobei das Bereitstellen der ersten halogenhaltigen Verbindung mit einem Duty Cycle von 1:5 gechoppt mit einem Takt von 30 Sekunden erfolgt.

8. Verfahren nach einem der vorhergehenden Ansprüche, wobei beim Ätzen eines Vias (300) durch ein Mehrschichtsystem (200), das zumindest eine Schicht (220) mit implantiertem Gallium umfasst, der Gasmengenstrom der zweiten halogenhaltigen Verbindung beim Ätzen der zumindest einen Schicht (220) mit implantiertem Gallium größer ist als beim Ätzen von Schichten (210, 230, 240, 250, 260, 270, 280) ohne implantiertes Gallium.

9. Verfahren nach einem der vorhergehenden Ansprüche, wobei mittels einer Kühlfalle (60) und/oder einer Ultraviolett-Lampe (70) der Wasserdampfpartialdruck in einer Vakuumkammer (10) verringert wird.

10. Verfahren nach einem der vorhergehenden Ansprüche, wobei der Elektronenstrahl des Elektronenstrahlgeräts (30) zum Abbilden einer zu ätzenden und/oder einer geätzten Oberfläche einer Schicht (110, 120, 130, 140, 150, 160, 210, 220, 230, 240, 250, 260, 270, 280) eingesetzt wird.

## Claims

1. A method for electron beam induced etching of a layer (120, 220) having gallium implanted, the method comprising the following steps:
a. Providing at least one first halogenated compound as an etching gas at a position at which an electron beam impacts on the layer (120, 220); and
b. providing at least one second halogenated compound as a precursor gas for removing the gallium at this position.

2. The method according to claim 1, wherein the at least one first halogenated compound comprises xenon difluoride.

3. The method according to claim 1 or 2, wherein the at least one second halogenated compound comprises chlorine.

4. The method according to one of the preceding claims, wherein the provision of the second halogenated compound occurs continuously during the etching.

5. The method according to claim 4, wherein the second halogenated compound is provided with a gas flow rate of 0.1 standard cubic centimetres per minute.

6. The method according to one of the preceding claims, wherein the provision of the first halogenated compound is varied during the etching.

7. The method according to claim 6, wherein the provision of the first halogenated compound occurs with a duty cycle of 1:5 and is chopped with a clock rate of 30 seconds.

8. The method according to one of the preceding claims, wherein, when etching a via (300) through a multi-layered system (200) having at least one layer (220) with implanted gallium, the gas flow of the second halogenated compound is larger when the at least one layer (220) with implanted gallium is etched than in the case when the layers (210, 230, 240, 250, 260, 270, 280) without implanted gallium are etched.

9. The method according to one of the preceding claims, wherein the vapour partial pressure in a vacuum chamber (10) is reduced by using a cold trap (60) and/or an ultraviolet lamp (70).

10. The method according to one of the preceding claims, wherein the electron beam of the electron beam apparatus (30) is used to image the surface of a layer to be etched and/or of an etched layer (110, 120, 130, 140, 150, 160, 210, 220, 230, 240, 250, 260, 270, 280).

## Revendications

1. Procédé de gravure induite par un faisceau d'électrons d'une couche (120, 220) contenant du gallium implanté, le procédé comprenant les étapes suivantes :
a. mise à disposition d'au moins un premier composé halogéné servant de gaz de gravure en un point sur lequel un faisceau d'électrons tombe sur la couche (120, 220) ; et
b. mise à disposition d'au moins un deuxième composé halogéné servant de gaz précurseur pour éliminer le gallium en ce point.

2. Procédé selon la revendication 1, dans lequel le ou les premiers composés halogénés comprennent du difluorure de xénon.

3. Procédé selon l'une des revendications 1 ou 2, dans lequel le ou les deuxièmes composés halogénés comprennent du chlore.

4. Procédé selon l'une des revendications précédentes, dans lequel la mise à disposition du deuxième composé halogéné s'effectue en continu pendant la gravure.

5. Procédé selon la revendication 4, dans lequel le deuxième composé halogéné est mis à disposition avec un débit massique de gaz de 0,1 centimètre cube normal par minute.

6. Procédé selon l'une des revendications précédentes, dans lequel la mise à disposition du premier composé halogéné a lieu d'une manière variable pendant la gravure.

7. Procédé selon la revendication 6, dans lequel la mise à disposition du premier composé halogéné s'effectue avec un facteur de marche de 1:5, pour une cadence de 30 secondes.

8. Procédé selon l'une des revendications précédentes, dans lequel, lors de la gravure d'un trou d'interconnexion (300) à travers un système multicouche, qui comprend au moins une couche (220) contenant du gallium implanté, le débit massique du gaz du deuxième composé halogéné est, lors de la gravure de la ou des couches (220) contenant du gallium implanté, supérieur à ce qu'il est lors de la gravure de couches (210, 230, 240, 250, 260, 270, 280) sans gallium implanté.

9. Procédé selon l'une des revendications précédentes, dans lequel la pression partielle de vapeur d'eau est diminuée dans une chambre à vide (10) à l'aide d'un piège cryogénique (60) et/ou d'une lampe à ultraviolet (70).

10. Procédé selon l'une des revendications précédentes, dans lequel le faisceau d'électrons de l'appareil à faisceau d'électrons (30) est utilisé pour former une image d'une surface à graver et/ou d'une surface gravée d'une couche (110, 120, 130, 140, 150, 160, 210, 220, 230, 240, 250, 260, 270, 280).
